# EUROPEAN PATENT APPLICATION

(11) **EP 2 065 945 A2**
(43) Date of publication of application: **03.06.2009**
(21) Application number: 08169811.0
(22) Date of filing: 24.11.2008
(51) Int. Cl.: H01L 31/12

(54) **Optical Interface between two sections of an Integrated Chip**

(30) Priority: 30.11.2007 US 948451
(71) Applicant: ITT Manufacturing Enterprises, Inc., Wilmington, Delaware 19801 (US)
(72) Inventor: Juett, Gregg T., Clearwater, FL 33756 (US)
(74) Representative: Esser, Wolfgang

(57) **Abstract**

An integrated electronic chip including a first section (102) formed on a first substrate; a second section (104) formed on a second substrate; and a chip package. The first section including a first electronic circuit electrically coupled to a first optical transmitter (106) and a first optical receiver (110). The second section including a second electronic circuit electrically coupled to a second optical transmitter (112) and a second optical receiver (108). The chip package configured to hold the first and second sections such that the first substrate is separated from the second substrate by a gap (113) having a predetermined width; first optical signals emitted by the first optical transmitter (106) are received by the second optical receiver(108); and second optical signals emitted by the second optical transmitter (112) are received by the first optical receiver (110). The first circuit is electrically isolated from the second circuit by the gap.

## Description

### FIELD OF THE INVENTION

The present invention concerns the use of optical interfaces between sections of an integrated electronic chip. In particular, the present invention allows for the production of integrated chips that include multiple electrically isolated sections.

### BACKGROUND OF THE INVENTION

The demand for more and more complicated integrated circuits that may be formed in a single integrated chip is driven by a desire for more compact electronic devices, as well as the potential for simplified post-fabrication assembly and packaging of these devices. Simplifying the assembly and packaging of electronic devices may improve durability and quality, as well as potentially decrease the cost of manufacture for the completed devices.

One difficulty that designers of such systems on a chip often face is ensuring proper electrical isolation between different circuits within these integrated chips. In multi-chip designs, electrical isolation can be achieved by placing circuits that are likely to experience undesirable levels of crosstalk in separate electrically isolated packages; however, in system on a chip designs, chip designers have no such luxury.

The present invention uses a new approach to isolate multiple sections of a single integrated chip.

### SUMMARY OF THE INVENTION

An exemplary embodiment of the present invention is an integrated electronic chip including: a first section formed on a first substrate; a second section formed on a second substrate; and a chip package. The first section including a first electronic circuit electrically coupled to a first optical transmitter and a first optical receiver. The second section including a second electronic circuit electrically coupled to a second optical transmitter and a second optical receiver. The chip package configured to hold the first and second sections such that the first substrate is separated from the second substrate by a gap having a predetermined width; first optical signals emitted by the first optical transmitter are received by the second optical receiver; and second optical signals emitted by the second optical transmitter are received by the first optical receiver. The first circuit is electrically isolated from the second circuit by the gap.

### BRIEF DESCRIPTION OF THE DRAWINGS

The invention is best understood from the following detailed description when read in connection with the accompanying drawings. It is emphasized that, according to common practice, the various features of the drawings are not to scale. On the contrary, the dimensions of the various features are arbitrarily expanded or reduced for clarity. Included in the drawing are the following Figs.:
- Fig. 1A: is a top plan drawing illustrating an exemplary integrated electronic chip including two optically coupled circuits according to the present invention.
- Fig. 1 B: is a side plan drawing illustrating another exemplary integrated electronic chip including two optically coupled circuits according to the present invention.
- Fig. 2: is a top plan drawing illustrating a further exemplary integrated electronic chip including three optically coupled circuits according to the present invention.
- Fig. 3: is a side plan drawing illustrating an additional exemplary integrated electronic chip including three optically coupled circuits according to the present invention.

### DETAILED DESCRIPTION OF THE INVENTION

Exemplary embodiments of the present invention include use of optical transmitters and receivers to relay data between circuits formed on separated substrates that have been mounted within a chip package so as to provide electrical isolation between the separate circuits.

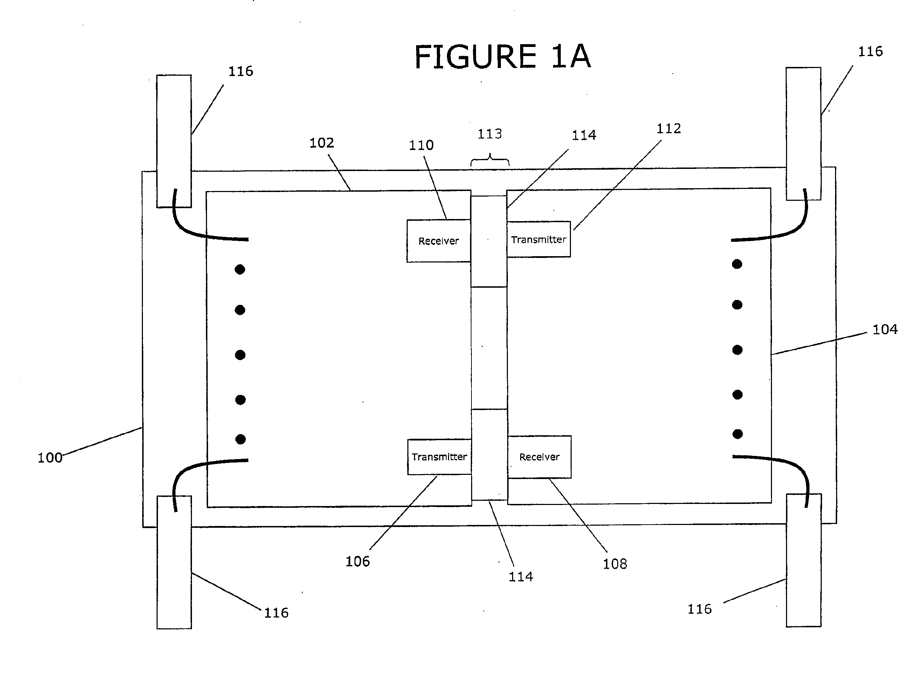

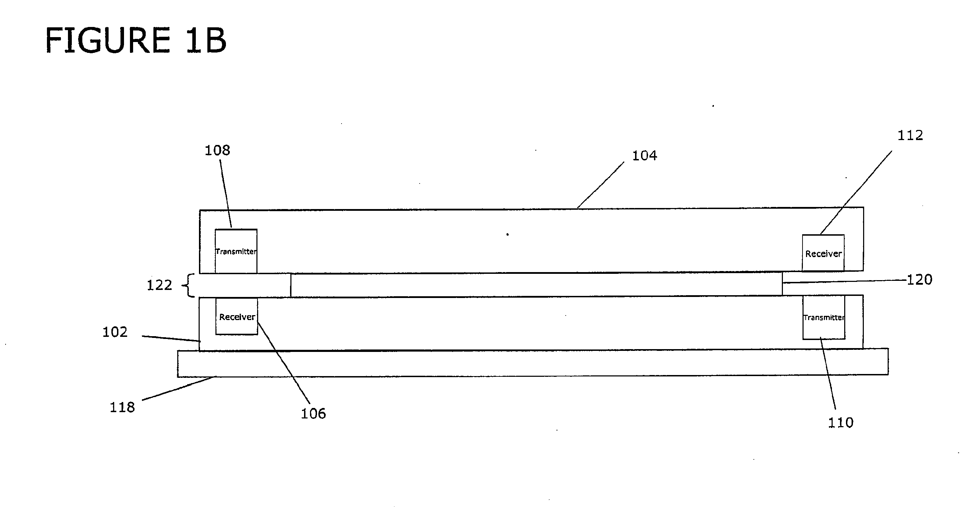

Fig. 1 illustrates one exemplary configuration of an integrated electronic chip according to the present invention that includes two physically separated sections within the chip package that are optically coupled, but not electrically coupled. This exemplary integrated electronic chip includes: substantially insulating base 100; first section 102 and second section 104, which are both mounted on substantially insulating base 100; substantially optically transmissive spacers 114, which are sandwiched between sections 102 and 104 in gap 113; and electrodes 116, which are each electrically coupled to one of sections 102 or 104.

Substantially insulating base 100 may be formed of any substantially insulating material including, but not limited to, plastics, ceramics, intrinsic semiconductors, glasses, and other dielectrics. The substrates of sections 102 and 104 of the integrated electronic chip may be mounted to substantially insulating base 100 using any standard technique used in the electronics industry. For example epoxies, solders, thermoplastics and elastomers may be used. Alternatively, substantially insulating base 100 may be designed such that sections 102 and/or 104 may be press-fit into depressions in the base or held by clamps (not shown).

It is noted substantially insulating base 100 may be only one portion of the package of an exemplary integrated electronic chip according to the present invention. For example, the chip package may also include a cover and/or potting material to encapsulate the exemplary integrated electronic chip.

Sections 102 and 104 may include any electronic circuits formed on a substrate, such as: radio frequency (RF) circuits; RF detection circuits; microwave circuits; microwave detection circuits; digital baseband circuits; logic circuits; and signal processing circuits. Also formed on the substrate of each section of an exemplary integrated electronic chip according to the present invention are an optical transmitter and an optical receiver. The optical transmitter and optical receiver are electrically coupled to the corresponding electronic circuit.

In Fig. 1, section 102 includes optical transmitter 106 and optical receiver 110, and section 104 includes optical transmitter 112 and optical receiver 108. Optical transmitter 106 of section 102 is aligned so that optical signals generated in the transmitter is transmitted across gap 113 through one of the substantially optically transmissive spacers 114 and is incident on optical receiver 108 of section 104. Optical transmitter 112 of section 104 is aligned so that optical signals generated in this transmitter is transmitted across gap 113 through the other substantially optically transmissive spacer 114 and is incident on optical receiver 110 of section 102. The optical receivers generate electric signals based on the received optical signals.

These optical transmitters and optical receivers allow data to be transferred between the electronic circuits in sections 102 and 104, without directly electrically coupling of the circuits. Also, the width of gap 113 may be selected such that any anticipated inductive coupling between the electronic circuits of sections 102 and 104 is reduced below a desired threshold level. Thus, in exemplary embodiments of the present invention, the electronic circuits of sections 102 and 104 may be electrically isolated sufficiently to reduce undesired electrical crosstalk between these electronic circuits, while still allowing desired data to be passed between the electronic circuits.

Optical transmitters 106 and 112 may include a self-modulated semiconductor optical source, such as an electroluminescent (EL) element; a light emitting diode (LED); and an edge emitting semiconductor laser, with associated modulation and drive circuitry. Alternatively, optical transmitters 106 and 112 may include a self-modulated semiconductor optical source, which is operated in a continuous wave (CW) mode, and a separate optical modulator, as well as associated modulation and drive circuitry. These optical transmitters may also include optical elements to direct and/or focus their generated optical signals toward the corresponding optical receivers. These optical transmitters may operate in any wavelength band; however, standard near infrared or visible optical communication bands may be most common.

Optical receivers 108 and 110 may include any type of semiconductor optical sensors, such as photoresistive sensors, photodiodes, and phototransistors. Optical receivers 108 and 110 also include associate circuitry and may include optical elements to improve coupling of the optical signals from the corresponding optical transmitters into optical sensors and/or reduce coupling of stray light from other sources, including that of the other optical transmitter(s), into the optical sensor.

It is desired that the majority of light detected by the optical receiver is due to the optical signals generated by the associated optical transmitter. Exemplary embodiments of the present invention may use a number of different approaches to achieve this goal. One approach is to arrange the optical transmitter/receiver pairs so that there is little, or no, direct crosstalk. For example, in the exemplary embodiment of Fig. 1A the optical transmitter/receiver pairs are located as far apart as practical. As discussed above, the optical transmitters and/or the optical receivers may also include optical elements to assist in coupling light between the optical transmitter and its corresponding optical receiver. These optical elements may also significantly reduce potential crosstalk between the optical transmitter/receiver pairs. Additionally, surfaces of the sections, other than the optical receivers, and/or chip package on which the optical signals may be incident may be formed of or coated with material selected to substantially absorb, or at least reduce reflections of the optical signals.

Another approach to reducing potential optical crosstalk is also illustrated in Fig. 1A. This exemplary integrated electronic chip is configured such that the optical signals of each optical transmitter/receiver pair are transmitted through a separate substantially optically transmissive spacer 114. These separate substantially optically transmissive spacers may function to at least partially guide the optical signals from the optical transmitter to the corresponding optical receiver, thereby reducing the amount of stray light within the chip package.

It is also contemplated that different optical transmitter/receiver pairs may be adapted to operate in different wavelength bands. For example, optical transmitter 106 may generate light having a first peak wavelength and optical transmitter 112 may generate light having a second peak wavelength, which is different from the first peak wavelength. Optical receiver 108 may be adapted to be more sensitive to the first peak wavelength, i.e. the optical signals of optical transmitter 106, than to the second peak wavelength. Optical receiver 110 may be adapted to be more sensitive to the second peak wavelength, i.e. the optical signals of optical transmitter 112, than to the first peak wavelength. Thus, optical receiver 108 preferentially receives the first optical signal and optical receiver 110 preferentially receives the second optical signal. These wavelength band differences may be implemented during fabrication of the optical sources and/or optical sensors or may be implemented by including wavelength selective optical elements, such as filters or gratings, in the optical transmitters, optical receivers, and/or the substantially optically transmissive spacers.

Substantially optically transmissive spacers 114 may be formed of any material that is substantially optically transmissive in the desired wavelength band and substantially electrically insulating. Such materials may include: glasses; plastics; silicon; quartz; alumina; sapphire; epoxies; elastomers; and thermoplastics. Substantially optically transmissive spacers 114 may be formed as a single bulk layer, a multilayer structure, or a laminated structure that is sandwiched between one or more optical transmitter/receiver pairs, when the sections are mounted in the chip package as illustrated in Fig. 1A. Alternatively, a substantially optically transmissive spacer may be formed by flowing a substantially transmissive potting material (such as an epoxy, elastomer, or thermoplastic) between the two sections as part of the chip packaging procedure. Although optically transmissive spacers 114 may help reduce optical crosstalk and/or may assist in positioning/holding sections 102 and 104 within the chip package, it is also contemplated, according to the present invention, that these optically transmissive spacers may be omitted from an exemplary integrated electronic chip.

Fig. 1B illustrates an alternative exemplary embodiment of the present invention. In the exemplary configuration of Fig. 1B, section 104 is stacked on top of section 102 instead of mounted beside it, as shown in the exemplary embodiment of Fig. 1A. Because only section 102 is directly in contact with package base 118, package base 118 does not have to be electrically insulating and instead may be a ground plane for section 102. Also because of the stacked configuration of this embodiment, it may be undesirable for optical transmitters 106 and 112 to include edge emitting semiconductor lasers, unless they also include a mirror to redirect the light vertically; however, optical transmitters 106 and 112 may desirably include a vertical cavity surface emitting laser (VCSEL).

Also illustrated in the exemplary embodiment of Fig. 1B is spacer 120. Spacer 120 separates sections 102 and 104 by gap 122; however, unlike substantially optically transmissive spacers 114 in the exemplary embodiment of Fig. 1A, the optical signals are not transmitted through spacer 120 in the exemplary embodiment of Fig. 1B. Spacer 120 may, therefore, be formed of any substantially electrically insulating material(s), whether substantially optically transmissive or not. It may even be desirable for spacer 120 to be substantially opaque to the wavelength band(s) of optical transmitters 106 and 112 in order to reduce optical crosstalk.

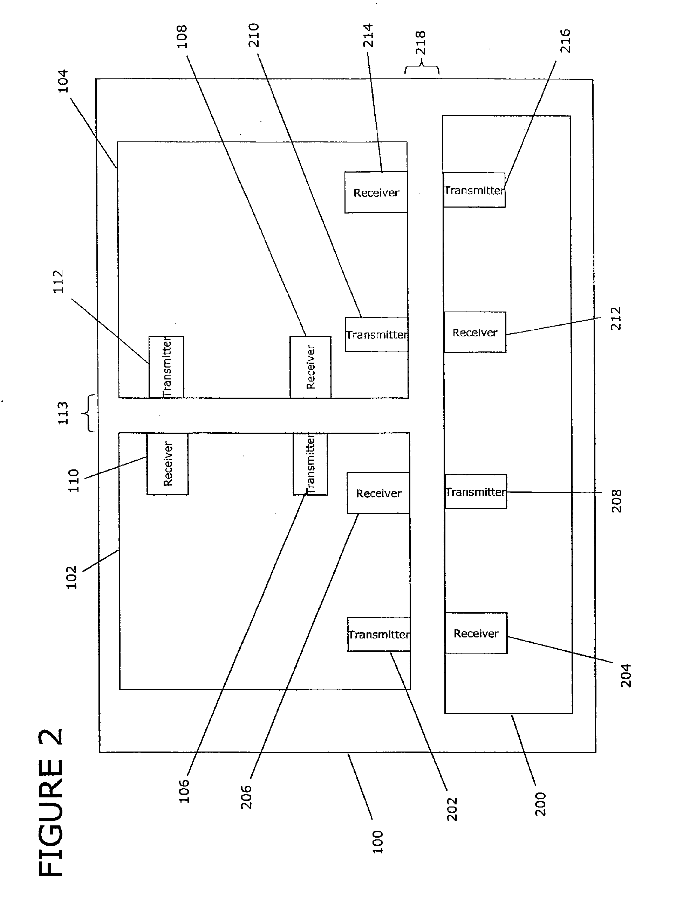

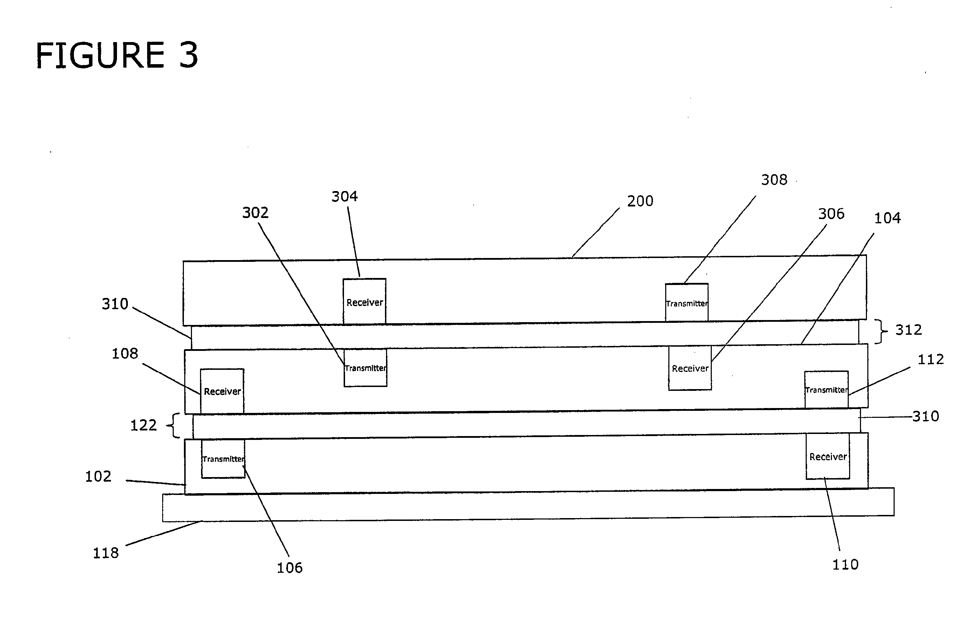

Figs. 2 and 3 illustrate two additional exemplary embodiments of the present invention. Two exemplary integrated electronic chips are shown, each including three separate sections 102, 104, and 200 that are electrically isolated, but optically coupled.

In the exemplary embodiment of Fig. 2, each section is mounted on substantially electrically insulating base 100 and includes two optical transmitters and two optical receivers. As in the exemplary embodiment of Fig. 1A, optical transmitter 106 of section 102 is aligned to transmit optical signals across gap 113 to optical receiver 108 of section 104; and optical transmitter 112 of section 104 is aligned to transmit optical signals across gap 113 to optical receiver 110 of section 102. Optical transmitter 202 of section 102 is aligned to transmit optical signals across gap 218 to optical receiver 204 of section 200. Optical transmitter 210 of section 104 is aligned to transmit optical signals across gap 218 to optical receiver 212 of section 200. Optical transmitters 208 and 216 of section 200 are aligned to transmit optical signals across gap 218 to optical receivers 206 of section 102 and 214 of section 104, respectively. Thus, each section is capable of directly exchanging data optically with both of the other sections.

It is noted that the exemplary embodiment illustrated in Fig. 2 does not include any spacers between the sections; however, one skilled in the art will understand that one or more spacers, such as those illustrated in Figs. 1A and 1B may be added in gaps 113 and/or 218 of this exemplary embodiment.

The exemplary embodiment of Fig. 3 illustrates three sections 102, 104, and 200 in an exemplary stacked configuration. In this exemplary stacked configuration, optical transmitter 106 of section 102 is aligned to transmit optical signals across gap 122 to optical receiver 108 of section 104; optical transmitter 112 of section 104 is aligned to transmit optical signals across gap 122 to optical receiver 110 of section 102; optical transmitter 302 of section 104 is aligned to transmit optical signals across gap 312 to optical receiver 304 of section 200; and optical transmitter 308 of section 200 is aligned to transmit optical signals across gap 312 to optical receiver 306 of section 104. Thus, section 104 is capable of directly exchanging optical data with both sections 102 and 200; however, sections 102 and 200 are not capable of directly exchanging optical data.

As described above with reference to the exemplary embodiment of Fig. 1B, chip base 118 is directly connected only to section 102 and, thus, it is not necessary for chip base 118 to be electrically insulating. The chip package of Fig. 3 also includes substantially optically transmissive spacers 310 in both gap 122 between section 102 and section 104 and in gap 312 between sections 104 and 200.

The present invention includes a number of exemplary embodiments of integrated electronic chips, having multiple electrically isolated circuits formed in separate sections. Although the invention is illustrated and described herein with reference to specific embodiments, it is not intended to be limited to the details shown. Rather, various modifications may be made in the details within the scope and range of equivalents of the claims and without departing from the invention. In particular, one skilled in the art may understand that many features of the various specifically illustrated embodiments may be mixed to form additional exemplary integrate electronic chips also embodied by the present invention.

## Claims

1. An integrated electronic chip comprising:
a first section (102) formed on a first substrate, the first section including a first electronic circuit electrically coupled to a first optical transmitter (106) and a first optical receiver (110);
a second section (104) formed on a second substrate, the second section including a second electronic circuit electrically coupled to a second optical transmitter (112) and a second optical receiver (108); and
a chip package (100) configured to hold the first section and the second section such that:
the first substrate is separated from the second substrate by a gap (113) having a predetermined width, whereby the first circuit is electrically isolated from the second circuit;
first optical signals emitted by the first optical transmitter (106) are received by the second optical receiver (108); and
second optical signals emitted by the second optical transmitter (112) are received by the first optical receiver (110).

2. An integrated electronic chip according to claim 1, wherein the first electronic circuit (102) is one of:
a radio frequency (RF) circuit;
an RF detection circuit;
a microwave circuit;
a microwave detection circuit;
a digital baseband circuit;
a logic circuit; or
a signal processing circuit.

3. An integrated electronic chip according to claim 1, wherein the first optical transmitter (106) includes one of:
a self-modulated electroluminescent (EL) element;
an EL element optically coupled to an optical modulator;
a self-modulated light emitting diode (LED);
an LED optically coupled to an optical modulator;
a self-modulated edge emitting semiconductor laser;
an edge emitting semiconductor laser optically coupled to an optical modulator;
a self-modulated vertical cavity surface emitting laser (VCSEL); or
a VCSEL optically coupled to an optical modulator.

4. An integrated electronic chip according to claim 1, wherein the first optical receiver (108) includes one of: a photoresistive sensor; a photodiode; or a phototransistor.

5. An integrated electronic chip according to claim 1, wherein:
the first optical transmitter (106) has a first peak wavelength;
the second optical transmitter (112) has a second peak wavelength different than the first peak wavelength;
a sensitivity of the first optical receiver (108) to the first peak wavelength is higher than its sensitivyt to the second peak wavelength; and
a sensitivity of the second optical receiver (110) to the second peak wavelength is higher than its sensitivity to the first peak wavelength.

6. An integrated electronic chip according to claim 1, wherein:
the chip package includes a substantially insulating base (100);
the first substrate (102) is mounted on the substratially insulating base; and
the second substrate (104) is mounted adjacent to the first substrate on the substantially insulating base such that:
the first substrate is separated from the second substrate by the gap (113);
the first optical signals emitted by the first optical transmitter are received by the second optical receiver; and
the second optical signals emitted by the second optical transmitter are received by the first optical receiver.

7. An integrated electronic chip according to claim 6, wherein the chip package further includes at least one substantially optically transmissive spacer sanwiched between the first section and the second section in the gap between the first substrate and the second substrate such that:
the first optical signals are transmitted through one of the at least one substantially optically transmissive spacer; and
the second optical signals are transmitted through one of the at least one substantially optically transmissive spacer.

8. An integrated electronic chip according to claim 7, wherein the at least one substantially optically transmissive spacer is formed of at least one of:
glass; plastic; silicon; quartz; alumina; sapphire; epoxy; elastomer; or thermoplastic.

9. An integrated electronic chip according to claim 1, wherein:
the chip package includes base (118) and at least one spacer (120);
the first substrate (102) of the first section is mounted on the base;
the at least one spacer is coupled to to the first section opposite from the base; and
the second section (104) is coupled to the at least one spacer opposite from the first section such that:
the first substrate is separated from the second substrate by the gap (122);
the first optical signals emitted by the first optical transmitter (108) are received by the second optical receiver (106); and
the second optical signals emitted by the second optical transmitter (110) are received by the first optical receiver (112).

10. An integrated electronic chip according to claim 9, wherein the at least one spacer includes at least one substantially optically transmissive spacer arranged such that:
the first optical signals are transmitted through one of the at least one substantially optically transmissive spacer; and
the second optical signals are transmitted through one of the at least one substantially optically transmissive spacer.

11. An integrated electronic chip according to claim 10, wherein the at least one substantially optically transmissive spacer is formed of at least one of: glass; plastic; silicon; quartz; alumina; sapphire; epoxy; elastomer; or thermoplastic.

12. An integrated electronic chip according to claim 1, wherein chip package includes:
a first plurality of electrodes (116) electrically coupled to the first circuit; and
a second plurality of electrodes (116) electrically coupled to the second circuit.

13. An integrated electronic chip according to claim 1, further comprising:
a third section (200) formed on a third substrate, the thrid section including a third electronic circuit electrically coupled to a third optical transmitter and a third optical receiver;
wherein:
the first electronic circuit of the first section is further electrically coupled to a fourth optical transmitter (202) and a fourth optical receiver (206); and
the chip package is configured to hold the first section, the second section, and the third section such that:
the first substrate is separated from the third substrate by another gap (218) having another predetermined width, whereby the first circuit is electrically isolated from the third circuit;
third optical signals emitted by the third optical transmitter (208) are received by the fourth optical receiver (206); and
fourth optical signals emitted by the fourth optical transmitter (202) are received by the third optical receiver (204).

14. An integrated electronic chip according to claim 13, wherein:
the second electronic circuit of the second section (104) is further electrically coupled to a fifth optical transmitter (210) and a fifth optical receiver (214);
the third electronic circuit (200) of the third section is further electrically coupled to a sixth optical transmitter (216) and a sixth optical receiver (212); and
the chip package is configured to hold the first section, the second section, and the third section such that:
the second substrate is separated from the third substrate by a further gap (218) having a further predetermined width, whereby the second circuit is electrically isolated from the third circuit;
fifth optical signals emitted by the fifth optical transmitter (210) are received by the sixth optical receiver; and
sixth optical signals emitted by the sixth optical transmitter (216) are received by the fifth optical receiver.
